# EUROPEAN PATENT APPLICATION

(11) **EP 0 649 045 A2**
(43) Date of publication of application: **19.04.1995**
(21) Application number: 94116026.9
(22) Date of filing: 11.10.1994
(51) Int. Cl.: G02F 1/133, B23K 26/02

(54) **Method of repairing disconnection of wiring of a liquid crystal substrate**

(30) Priority: 14.10.1993 JP 256215/93
(71) Applicant: NEC CORPORATION, Tokyo (JP)
(72) Inventor: Haba, Belgacem, Minato-ku, Tokyo (JP); Morishige, Yukio, Minato-ku, Tokyo (JP)
(74) Representative: Glawe, Delfs, Moll & Partner

(57) **Abstract**

The invention provides a method of depositing a patterned thin layer for repairing a wiring disconnection of a liquid crystal wiring substrate (12). The method includes the steps of positioning a medium (15) in the vicinity of or in contact with the disconnection of the substrate (12), and radiating a laser beam to the medium (15) so that a material produced by a thermal decomposition of the medium (15) is stuck to the disconnection to form a patterned thin layer for repairing the disconnection. Since the method does not need the steps of applying a medium to a substrate, heating a substrate, and washing a substrate after a modification has been completed, all of these steps are required in conventional methods, it takes only 30 seconds per a repairing, whereas the conventional methods took about 5 minutes.

## Description

### BACKGROUND OF THE INVENTION

The invention relates to a method of repairing a disconnection of wiring of a liquid crystal wiring substrate, and more particularly to such a method in which a patterned thin layer is formed on a disconnection to thereby repair a disconnection.

One of known methods for forming a patterned thin layer for modifying a wiring of a liquid crystal wiring substrate includes the steps of applying a medium on a substrate, the medium precipitating a metal due to thermal decomposition thereof, and radiating laser beams to the medium in accordance with a desired modification pattern to thereby decompose the medium to precipitate a metal by which the wiring is modified. For instance, U.S. Patent No. 5,164,565 issued to Addiego et al. on November 17, 1992 has suggested a thin patterned layer forming method including the steps of discharging a solution in which a palladium acetate is dissolved in an organic solvent, through a thin nozzle of a dispenser onto a substrate to thereby partially form a palladium acetate layer on the substrate, heating the substrate to remove the solvent from the layer, and scanning laser beams in accordance with a desired modification pattern to thereby precipitate palladium on the substrate.

In the aforementioned method, since the minimum width of the palladium acetate layer formed on the substrate is relatively wider, specifically about 200 micrometers, the method requires to include steps of washing out unnecessary palladium acetate, after a wiring has been formed, located in the vicinity of the wiring, and raising a temperature of the substrate for removing a solvent from the palladium acetate layer. Thus, the conventional method takes much time for modification of wiring, and has complicated steps, resulting in that the conventional method is not so practical in terms of a throughput when the method is to be applied to mass production such as a liquid crystal wiring substrate. In addition, in the aforementioned method, a substrate is strongly bonded to a palladium acetate due to the heating of the substrate carried out for removal of a solvent, and hence unnecessary palladium acetate often cannot be sufficiently removed in a step for washing the substrate to be carried out after the modification of a wiring. This causes a lowering of a modification yield.

### SUMMARY OF THE INVENTION

In view of the foregoing problems, it is an object of the present invention to provide a method which does not require the washing step and solvent removing step as above mentioned to thereby remarkably shorten an operation time, and also remarkably improve a modification yield.

The invention provides a method of depositing a patterned thin layer for repairing a wiring disconnection of a liquid crystal wiring substrate, the method including the steps of positioning a medium to be transferred to the disconnection, in the vicinity of or in contact with the disconnection of the liquid crystal wiring substrate, and radiating a laser beam to the medium so that a material produced by a thermal decomposition of the medium is stuck to the disconnection to form a patterned thin layer for repairing the disconnection.

The medium to be transferred to a disconnection may be arranged on a support through which a laser beam is able to pass.

The medium preferably has the same width as that of a wiring of the liquid crystal wiring substrate.

In a preferred embodiment, a plurality of mediums to be transferred to the disconnection are arranged on the support in a desired pattern.

In another preferred embodiment, each of the plurality of mediums is differently oriented.

In still another preferred embodiment, some of the plurality of mediums are oriented in a first direction, and the others are oriented in a second direction perpendicular to the first direction.

In yet another preferred embodiment, one of the plurality of mediums is selected and transferred to the disconnection.

In still yet another preferred embodiment, the plurality of mediums have different shapes from each other.

In further preferred embodiment the support is a teflon film.

In further preferred embodiment, the support is composed of a transparent material coated with a teflon film.

In further preferred embodiment, the support is composed of an organic film which produces a gas when heated.

In further preferred embodiment, the support is adapted to be movable so that the medium is aligned with the disconnection.

In further preferred embodiment, the medium to be transferred to the disconnection is composed of a palladium acetate.

In further preferred embodiment, the palladium acetate is applied to the support by applying the palladium acetate entirely over the support, drying the palladium acetate, and scanning pulse laser beams on the support to evapotranspire unnecessary portions of the palladium acetate.

In further preferred embodiment, the support is attached to a thin quartz plate having a plurality of slits disposed in parallel to each other. The mediums are disposed in alignment with the slits so that a laser beam is radiated to the mediums through the support and the slits.

The advantages obtained by the aforementioned present invention will be described hereinbelow.

In the method in accordance with the invention, laser beams are radiated to a medium with the medium being kept in contact with a substrate, to thereby transfer a material produced by thermal decomposition of the medium to the substrate. In the method, all of the steps, which were required in the conventional method, of applying a material from which a patterned thin layer is formed, to a substrate, drying the material, washing out the material from the substrate after transferring, and removing a solvent from the substrate are no longer required. As a result, the invention takes only about 30 seconds for forming a patterned thin layer, whereas the conventional method takes about 5 minutes. In addition, the invention remarkably increases a yield of forming patterned thin layers relative to the conventional method because the aforementioned washing step is no longer required. Furthermore, an apparatus for carrying out the method has a simple structure, and hence is easy in maintenance, and further it is possible to decrease a cost for manufacturing the apparatus.

The above and other objects and advantageous features of the present invention will be made apparent from the following description made with reference to the accompanying drawings, in which like reference characters designate the same or similar parts throughout the drawings.

### BRIEF DESCRIPTION OF THE DRAWINGS

Fig. 1 is a schematic view illustrating an embodiment in accordance with the invention.

Fig. 2 is a partial perspective view illustrating a detail of and around the support member 14 illustrated in Fig. 1

Fig. 3 is a perspective view illustrating another structure of the support member 14.

Fig. 4 is a flow chart of the method in accordance with the invention.

### DESCRIPTION OF THE PREFERRED EMBODIMENTS

A preferred embodiment in accordance with the present invention will be explained hereinbelow with reference to drawings.

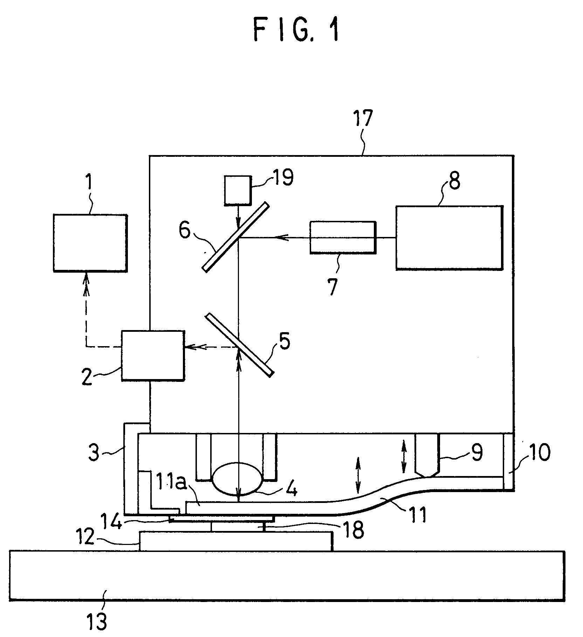

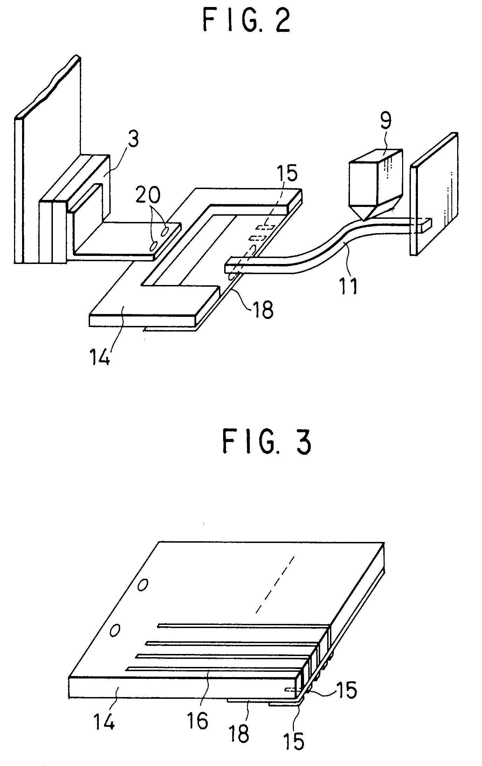

Fig. 1 illustrates an example of an apparatus for use with the method in accordance with the invention. The apparatus includes a microscopic optical system 17 for observing a pattern of a liquid crystal wiring substrate and also for radiating laser beams, a teflon film 18 as a support through which the laser beams can pass, a support member 14 on which the teflon film 18 is fixed, a substrate 12, a X-Y stage 13 on which the substrate 12 is placed, a mechanism 3 for slightly moving the support member 14 in a X-Y plane, a mechanism, including a lift mechanism 9, a fulcrum 10 and a bar 11, for compressing the teflon film 18 onto the substrate 12, and a monitor television 1 and a television camera 2 for photographing and monitoring a field observed by the microscopic optical system 17. On a bottom surface of the teflon film 18 are arranged a plurality of mediums 15 (not illustrated in Fig. 1, but illustrated in Fig. 2) to be transferred to the substrate 12.

The microscopic optical system 17 includes a laser beam source 8 which radiates laser beams for observation, a scanner 7 for scanning the laser beams, an illumination light source 19 for radiating illumination lights, a mirror 6 for combining the illumination lights and laser beams, a lens 4 for focusing the combined lights on the teflon film 18, and a half-mirror 5 located intermediate between the mirror 6 and the lens 4.

The substrate 12 having a disconnection defect in liquid crystal wiring is placed on the X-Y stage 13, and the microscopic optical system 17 can observe an area of the substrate 12 in which a disconnection is located, from the top of the substrate 12.

The microscopic optical system 17 includes an optical path through which the illumination lights radiated from the illumination light source 19 forward through the mirror 6, the half-mirror 5 and the lens 4 to the substrate 12. The microscopic optical system 17 also includes an optical system in which the half-mirror 5 reflects the reflected lights from the substrate 12, indicated by double arrows and a broken line, to the TV camera 2 to display the images of the reflected lights from the substrate 12 on the monitor television screen 1. The laser beam source 8 in the microscopic optical system 17 radiates argon laser beams, and the scanner 7 scans the laser beams radiated from the source 8 in X-Y directions within a top surface of the substrate 12. The laser beams radiated from the laser beam source 8 are reflected by the mirror 6 and then introduced to the substrate 12 through the half-mirror 5 and the lens 4.

The teflon film 18 on which the mediums 15 to be transferred to the substrate 12 are arranged is supported by the support member 14 between the lens 4 and the substrate 12. The mechanism 3 for slightly moving the support member 14 enables one of the mediums 15 which has a desired shape to be located on the optical path of the microscopic optical system 17. The bar 11 has a free end portion 11a through which the optical path of the microscopic optical system 17 passes and to which the support member 14 is attached, and can slightly raise and lower the support member 14 by the lift mechanism 9 and the fulcrum 10 of the bar 11. More specifically, when the lift mechanism 9 moves downwardly, the bar 11 is pushed downwardly, and when the lift mechanism 8 moves upwardly, the bar 11 also moves upwardly due to the resilience thereof. The free end portion 11a of the bar 11 is composed of quartz and has a thickness of 20 micrometers.

Fig. 2 illustrates a detailed structure of the support member 14. To the support member 14 is secured the teflon film 18 to which a plurality of the mediums 15 to be transferred to the substrate 12 are attached. In the embodiment, 200 mediums are attached to a lower surface of the teflon film 18. The mediums 15 are composed of palladium acetate, and are rectangular in shape having width of 20 micrometers and length ranging 10 to 100 micrometers. Some of longitudinal axes of the mediums 15 are oriented in an X direction, and the others are oriented in a Y direction. The rectangular-patterned palladium acetate 15 are applied to a lower surface of the teflon film 18 by a method including the steps of applying the palladium acetate entirely over the teflon film 18, drying the palladium acetate, and scanning the lower surface of the teflon film 18 with pulse laser beams to evapotranspire unnecessary portions of the palladium acetate. The teflon film 18 is formed to be a transparent susceptor comprising quartz coated with teflon having a weak adhesive force. When all of the palladium acetate mediums 15 have been transferred to the substrate 12, it is possible to detach the support member 14 from the mechanism by pulling out pins 20 connecting the support member 14 to the mechanism 3, and replace the teflon film 18 with a new one on which another 200 mediums are disposed. The mediums 15 have the same width as that of a wiring of the liquid crystal wiring substrate 12 in order to avoid that fragments of the mediums 15 are attached to the substrate 12 in the vicinity of a modified area to thereby contaminate the substrate 12.

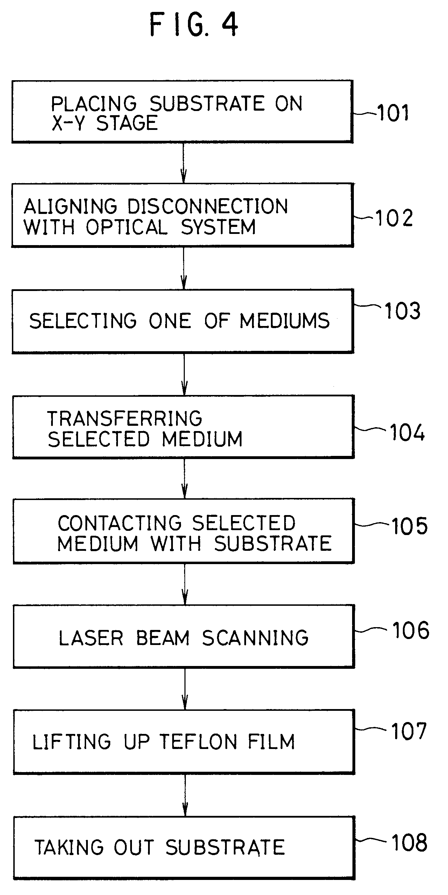

Fig. 4 is a flow chart showing the steps of the method in accordance with the embodiment. First, the substrate 12 was disposed in place on the X-Y stage 13 in step 101. Then, in step 102, the X-Y stage 13 and hence the substrate 12 were moved based on positional data of a disconnection provided from an inspector so that the disconnection was located at the center of an observation field of the microscopic optical system 17. Then, a medium which had most analogous shape with the disconnection was selected among a plurality of the mediums 15 in step 103. Then, the mechanism 3 was operated so that the selected medium 15 was located above the disconnection in step 104. At this time, the selected medium 15 was spaced from the substrate 12 by approximately 30 micrometers. Then, the lift mechanism 9 deflected the teflon film 18 with the bar 11 until the selected medium 15 contacted with the substrate 12 in step 105. While the selected medium 15 was in contact with the disconnection of the substrate 12, the laser beam source 8 radiated laser beams and the scanner 7 scanned the selected medium 15 with the laser beams in step 106. By laser beams scanning, the palladium acetate medium 15 was thermally decomposed and hence palladium was secured to the disconnection of the substrate 12. Since the teflon film 18 has a weak adhesion and hence it is difficult to adhere to the teflon film 18, the palladium did not adhere to the teflon film 18. In the embodiment, the deposition of palladium layer could be formed on the substrate 12 under the conditions that the laser beam diameter was 5 micrometers, the laser beam scanning velocity was 200 micrometers per second, the thickness of the palladium acetate layer was 1.5 micrometers, and the laser beam intensity was in the range of 5 mW to 30 mW. The deposited palladium layer had a thickness of 1500 angstroms and a specific resistance of 20 µΩcm, which was sufficiently low. The connection resistance measured after the disconnection having a length of 100 micrometers had been corrected was about 5 Ω. This was a sufficiently practical value. After the palladium layer had been deposited on the substrate 12, the lift mechanism 9 lifted the support member 14 up in step 107, and then the substrate 12 was detached from the support member 14 in step 108.

Since the invention does not need the steps of applying palladium acetate to a substrate, heating a substrate, and washing a substrate after a modification has been completed, all of these steps are required in conventional methods, it takes only 30 seconds per a modification , whereas the conventional methods took about 5 minutes. The embodiment assures a high space resolution of approximately 2 micrometers.

Fig. 3 illustrates a variation of the support member 14 to which the mediums 15 are to be attached. The support member 14 is composed of a thin quartz plate having a plurality of thin slits 16. To a lower surface of the support member 14 is attached the teflon film 18 at a portion of the support member 14 in which the slits 16 extend. To the teflon film 18 are attached a plurality of the mediums 15 each of which has different shapes from each other. The support member 14 illustrated in Fig. 3 makes it possible not to transfer a deflection to the mediums 15 since the bar 11 raises and lowers only the support member 14 having the slits 16, and hence provides an advantage that the mediums 15 are not prone to peel off from the teflon film 18. It should be noted that the embodiment uses a teflon film to which the mediums 15 are to be attached, however, an organic film may be used instead which is thermally decomposed and produce gases. In an embodiment in which an organic film is used, when the palladium acetate is decomposed by the radiation of laser beams, the organic film is also gasified due to the raise of a temperature. Hence, palladium does not adhere to the organic film, and accordingly the palladium is facilitated to adhere to the substrate 12 due to the gas pressure. In addition, it is also possible to compose the support member 14 of an acetate family film which is well adhesive to the palladium acetate mediums, and thereby the occurrence of peeling off of the patterned palladium acetate from the film can be reduced.

## Claims

1. A method of depositing a patterned thin layer for repairing a wiring disconnection of a liquid crystal wiring substrate (12), characterized by the steps of:
positioning a medium (15) to be transferred to the disconnection, in the vicinity of or in contact with the disconnection of the liquid crystal wiring substrate (12); and
radiating a laser beam to the medium (15) so that a material produced by a thermal decomposition of the medium (15) is stuck to the disconnection to form a patterned thin layer for repairing the disconnection.

2. The method in accordance with claim 1, wherein the medium (15) is placed on a support (18) through which a laser beam is able to pass.

3. The method in accordance with claim 1 or 2, wherein the medium (15) has the same width as that of a wiring of the liquid crystal wiring substrate (12).

4. The method in accordance with claim 2, wherein a plurality of mediums (15) to be transferred to the disconnection are arranged on the support (18) in a desired pattern.

5. The method in accordance with claim 4, wherein each of the plurality of mediums (15) is differently oriented.

6. The method in accordance with claim 4, wherein some of the plurality of mediums (15) are oriented in a first direction, and the others are oriented in a second direction perpendicular to the first direction.

7. The method in accordance with claim 4, wherein one of the plurality of mediums (15) is selected and transferred to the disconnection.

8. The method in accordance with claim 4, wherein the plurality of mediums (15) have different shapes from each other.

9. The method in accordance with any one of claims 2 to 8, wherein the support (18) comprises a teflon film (18).

10. The method in accordance with claim 9, wherein the support (18) comprises a transparent material coated with a teflon film (18).

11. The method in accordance with any one of claims 2 to 8, wherein the support (18) comprises an organic film which produces a gas when heated.

12. The method in accordance with any one of claims 2 to 11, wherein the support (18) is adapted to be movable so that the medium (15) is aligned with the disconnection.

13. The method in accordance with any of the preceding claims, wherein the medium (15) comprises a palladium acetate (15).

14. The method in accordance with claim 13, wherein the palladium acetate (15) is applied to the support (18) by applying the palladium acetate (15) entirely over the support (18), drying the palladium acetate (15), and scanning pulse laser beams on the support (18) to evapotranspire unnecessary portions of the palladium acetate (15).

15. The method in accordance with any one of claims 2 to 14, wherein the support (18) is attached to a thin quartz plate (14) having a plurality of slits (16) disposed in parallel to each other, the mediums (15) being disposed in alignment with the slits (16) so that the laser beam is radiated to the mediums (15) through the slits (16).
